(19) Europäisches Patentamt
European Patent Office
Office européen des brevets

(11) **EP 2 060 922 A1**

(12) **EUROPEAN PATENT APPLICATION**

(43) Date of publication:
**20.05.2009 Bulletin 2009/21**

(51) Int Cl.:
***G01R 1/073*** *(2006.01)*

(21) Application number: **07425727.0**

(22) Date of filing: **16.11.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(71) Applicant: **Technoprobe S.p.A**
**23870 Cernusco Lombardone (Lecco) (IT)**

(72) Inventors:
• **Lazzari, Stefano**
  **23874 Montevecchia (Lecco) (IT)**
• **Liberini, Riccardo**
  **23871 Lomagna (Lecco) (IT)**

(74) Representative: **Zambardino, Umberto**
**Botti & Ferrari S.r.l.**
**Via Locatelli, 5**
**20124 Milano (IT)**

(54) **Microstructure testing head**

(57) The invention describes a microstructure testing head (10) of the type comprising a plurality of contact probes (6) inserted in guide holes (4, 5) made in an upper guide (2) and in a lower guide (3), separated by an air gap (9). Advantageously, the testing head (10) according to the invention comprises at least one guide element (20) equipped with additional guide holes (21) for the passage of the contact probes (6) and made in the air gap (9) near to at least one of the upper and lower guides (2, 3).

The invention also describes a method for assembling a microstructure testing head (10) made according to the invention.

FIG. 3A

EP 2 060 922 A1

## Description

Field of application

The present invention refers to a microstructure testing head.

More specifically, the invention refers to a microstructure testing head of the type comprising a plurality of contact probes inserted in guide holes made in an upper guide and in a lower guide, separated by an air gap.

The invention also refers to a method for assembling a microstructure testing head.

In particular, but not exclusively, the invention concerns a testing head with vertical probes and the following description refers to this field of application with the sole purpose of simplifying its explanation.

Prior art

As is well known, a testing head is essentially a device suitable for placing a plurality of contact pads of a microstructure in electrical contact with corresponding channels of a measurement machine that performs its test.

The test performed on integrated circuits acts to detect and isolate defective circuits already in the production step. Normally, testing heads are then used for the electrical test of the integrated circuits on wafers before cutting and mounting them inside a chip containment package.

A testing head essentially comprises a plurality of mobile contact elements or contact probes held by at least one pair of plates or substantially plate-shaped guides that are parallel to one another. Such guides are equipped with suitable holes and placed a certain distance apart so as to leave a free area of an air gap for the movement and possible deformation of the contact probes. The pair of guides in particular comprises an upper guide and a lower guide, both provided with guide holes in which the contact probes, normally consisting of wires of special alloys with good electrical and mechanical properties, slide axially.

The good connection between the contact probes and the contact pads of the device being tested is ensured by the pressing of the testing head on the device itself, the mobile contact probes, during such pressing contact, undergoing a flexing inside the air gap between the two guides. Testing heads of this type are commonly known as vertical probes.

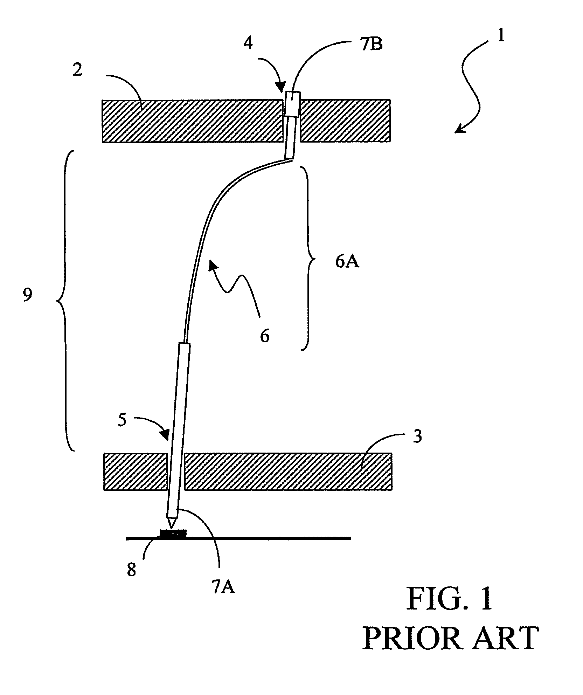

Basically, vertical probe testing heads have an air gap in which a flexing of the contact probes takes place, such flexing being able to be helped through a suitable configuration of the probes themselves or of their guides, as schematically illustrated in figure 1, where for the sake of simplicity of illustration just one contact probe of the plurality of contact probes normally included in a testing head has been represented.

In particular, figure 1 schematically illustrates a testing head 1 comprising at least one upper guide 2 and a lower guide 3, having respective upper and lower guide holes. 4 and 5 respectively, in which at least one contact probe 6 slides.

The contact probe 6 has at least one contact end or tip 7A. By the term tip, here and hereafter we mean an end portion, not necessarily pointed. In particular, the contact tip 7A abuts on a contact pad 8 of a device to be tested, making the mechanical and electrical contact between said device and a testing apparatus (not represented) of which such a testing head constitutes a terminal element.

In some cases, the contact probes arc fixedly connected to the head itself at the upper guide: in this case they are testing heads with locked probes.

More frequently, however, testing heads are used that have probes that are not fixedly connected, but held interfaced with a so-called board through a space transformer: in this case they are testing heads with unlocked probes.

In this case, as illustrated in figure 1, the contact probe 6 has a further contact tip 7B towards a plurality of contact pads of the space transformer, not illustrated as it is conventional. The good electrical contact between probes and space transformer is ensured in an analogous way to the contact with the device to be tested through the pressing of the probes on the contact pads of the space transformer.

The upper and lower guides 2 and 3 respectively are suitably spaced from an air gap 9 that allows the deformation of the contact probes 6. Finally, the upper and lower guide holes 4 and 5 are sized so as to allow the contact probe 6 to slide inside them.

The shape of the deformation undergone by the probes and the force necessary to produce such a deformation depend upon numerous factors, such as:

- the physical characteristics of the alloy that makes up the probes;

- the value of the misalignment between guide holes in the upper guide and corresponding guide holes in the lower guide.

It should be noted that for a correct operation of the testing head, the contact probes must have a suitable degree of freedom of axial movement inside the guide holes. In this way, such contact probes can also be withdrawn and replaced in the case of a single probe breaking, without having to replace the entire testing head.

All of these characteristics should therefore be evaluated and calibrated in the step of making a testing head, the good electrical connection between probes and device to be tested having to always be ensured.

Moreover, it should be remembered that the correct operation of a testing head is fundamentally linked to two parameters: the vertical displacement, or overtravel, of the contact probes and the horizontal displacement, or scrub, of the contact tips of such contact probes. In particular, it is extremely important to ensure the scrub of the contact tips that allows the "cleaning" of the surface of the contact pads, improving the contact made by the testing head.

In the case of a testing head 1 made with technology known as Cobra, the contact probes 6 have a predeformed configuration with a misalignment between the contact tips 7A and 7B, as illustrated in figure 1. In this case, the contact probe 6 comprises a predeformed portion 6A, which, even in the absence of contact of the testing head 1 with the device to be tested, helps the correct flexing of the contact probe 6 during its operation, in other words when in pressing contact with such a device.

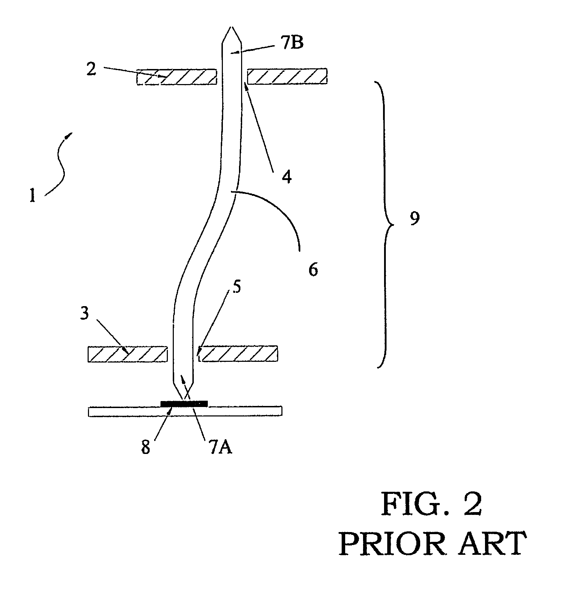

It is also known to make testing heads using so-called "shifted plate" technology, schematically illustrated in figure 2, elements that are structurally and functionally identical to the testing head 1 of figure 1 having been indicated with the same reference numerals.

In such a case, the contact probes 6 are not preformed, but are made straight, with a constant circular cross section for the entire length and in general pointed at the ends.

In order to obtain the correct operation of the contact probes 6, the upper and lower guides 2 and 3 are suitably shifted with respect to each other to allow a preferential flexing of the contact probes 6 in the same direction.

The assembly of the contact probes 6 in testing heads performed with shifted plate technology is very simple and fast. In particular, it is sufficient to align the upper and lower guides 2 and 3 with each other so as to also align the corresponding guide holes 4 and 5, then slot the contact probes 6 in the guide holes 4 and 5, shift the guides with respect to each other by a suitable amount then locking them in position.

In his case, however, the risk of the contact probes 6 slipping out is very high during maintenance and cleaning operations of the testing head 1, operations that are normally carried out with puffs of air or ultrasound and thus create mechanical stresses on the contact probes 6, making it easier for them to slip out fro the guide holes.

In any case, known testing heads 1 have a restriction linked to the distance between two contiguous probes of the testing head 1 that must be evaluated, according to the circular cross section of the wire that makes the contact probes 6, to avoid any contact between contiguous probes, in all of the positions that such probes take up during the operation of the testing head.

Such a restriction translates into a limitation of the minimum distance value between centre and centre of two contact pads of the integrated electronic device to be tested, known in the field by the term "pitch". In particular, the minimum pitch value of the device to be tested depends upon the geometric configuration and the size of the probes of the testing head used to test it. In order to avoid contact between contiguous probes, the testing head 1. must satisfy the following relationship;

$$P > \varnothing F + G1$$

where:

P is a pitch value of the device to be tested, i.e. the distance between centre and centre of two successive contact pads;

ØF is the diameter of the contact probes 6; and

G1 is a safety distance between adjacent contact probes 6.

The condition G1=0, in other words the safety distance reaching zero, corresponds to the collision between the probes.

The need to keep a minimum pitch value to ensure a correct distance between the probes in all operating conditions of the testing head 1 is therefore in contrast with the current market requirement driving towards designing increasingly dense devices and therefore it requires testing heads with an ever greater number of contact probes for the testing of such devices.

The risk of contact between contiguous probes is particularly great in the condition of pressing contact between the testing head and the device to be tested, when the contact probes 6 arc flexed and/or deformed, such flexing and/or deformation indeed increasing the risk of contact between contiguous probes.

The technical problem forming the basis of the present invention is to devise a microstructure testing head capable of ensuring a correct electrical contact with a device to be tested as well as ensuring that the probes are held in position correctly inside the guides, at the same time minimising the risk of contact between adjacent probes that have undergone a flexing and/or a deformation.

Summary of the invention

The idea for a solution forming the basis of the present invention is to insert a guide element for the contact probes at at least one of the guides of the testing head that is capable of forcing a flexing and/or deformation direction of the probes themselves.

Based upon such an idea for a solution the technical problem is solved by a microstructure testing head of the type indicated previously and defined by the characterising part of claim 1.

Such a technical problem is also solved by a method for assembling a testing head defined by the characterising part of claim 15.

The characteristics and advantages of the testing head according to the invention shall become clearer from the following description of an example embodiment thereof, given for indicating and not limiting purposes with reference to the attached drawings.

Brief description of the drawings

In such drawings:

Figures 1 and 2 schematically show a testing head made according to the prior art;

Figures 3A and 3B schematically show a testing head made according to the invention;

Figures 4A-4B and 5A-5B schematically show the testing head of figure 3B in different operating conditions;

Figures 6A-6B and 7A-7B schematically show a first variant embodiment of the testing head according to the invention in different operating conditions; and

Figures 8A-8D schematically show different operative steps of an assemble method according to the invention.

Detailed description

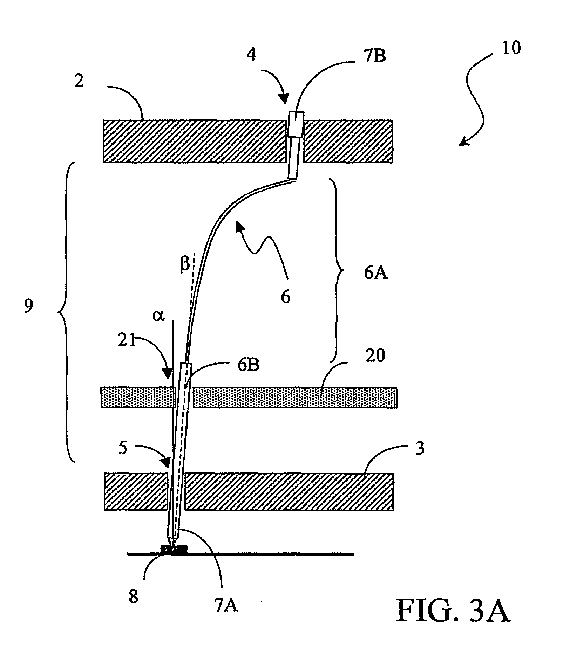

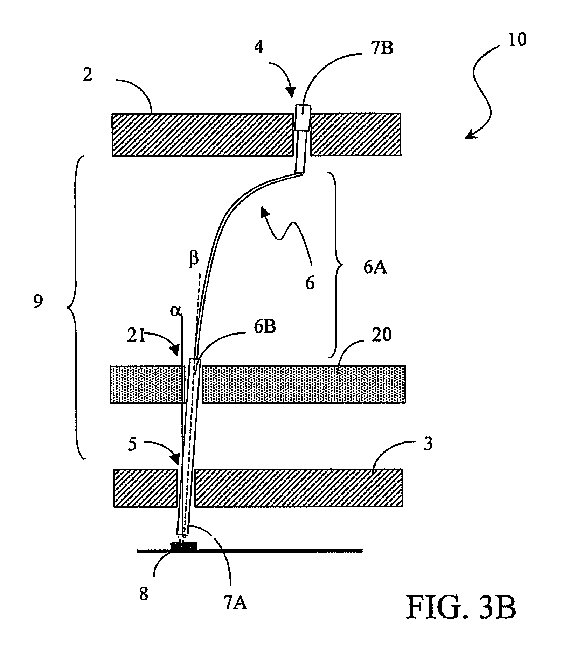

With reference to such figures, and in particular to figure 3, a testing head made according to the invention is schematically illustrated, wholly indicated with 10. Elements that structurally and functionally correspond to the testing heads described in relation to the prior art and illustrated in figures 1 and 2 shall be attributed the same reference numerals for the sake of simplicity of presentation.

The testing head 10 according to the invention thus comprises at least one upper guide 2 and one lower guide 3, having respective upper and lower guide holes 4 and 5 respectively, in which at least one contact probe 6 slides. Also in this case, for the sake of simplicity of illustration, just one contact probe of the plurality of contact probes normally included in a testing head has been represented.

The contact probe 6 has at least one contact end or tip 7A with a contact pad 8 of a device to be tested. In the embodiment shown as an example in figure 3A, the contact probe 6 also has a further contact tip 7B towards a plurality of contact pads of a space transformer (not illustrated), the testing head 10 being of the type with unlocked probes.

Moreover, the contact probe 6 has a predeformed section 6A, arranged at an air gap 9 that separates the guides 2 and 3.

In conditions of pressing contact with the device to be tested, the contact probes 6 in general undergo a flexing and/or a deformation, hereafter generically indicated as deformation.

Advantageously according to the invention, the testing head 10 also comprises a guide element 20 for the contact probes, made near to at least one of the upper or lower guides 3 and equipped with suitable additional guide holes 21 for the passage of the contact probes.

In particular, in the example of figure 3A, such a guide element is positioned inside the air gap 9 at the lower guide 3. Moreover, such a guide element 20 comprises holes 21 arranged so that they correspond to the guide holes 4 and 5, made in the upper and lower guide 2 and 3 respectively, and with diameters equivalent to them. Basically, a guide hole 4 or 5 corresponds to an additional guide hole 21 for the passage of corresponding probes.

In general, the additional guide holes 21 have axes coinciding with axes of the upper and/or lower guide holes 4, 5. In this case, it should be noted that the holding carried out by the guide element 20 on an end portion of the contact probes 6, at the contact tips 7A and/or 7B, makes it easier for them to slide inside the guide holes and reduces the risk of the probes jamming.

Preferably, as illustrated in figure 3A, the additional guide holes 21 of the guide element 20 are positioned so that they are shifted with respect to the lower guide holes 5 of the lower guide 3, with respect to a first direction $\alpha$ (indicated in the figures with a full line) corresponding to an axis of such lower guide holes 5, forcing a portion of probe 6B defined by the guide element 20 and by the lower guide 3 in a second direction $\beta$ (indicated in the figures with a broken line). In this way, the additional guide holes 21 and lower guide holes 5 have axes that are substantially parallel but do not coincide.

Basically, defining a longer direction of extension of the upper and lower guides 2, 3 as horizontal, considering a longer direction of extension of the upper and lower guide holes 4, 5 made transversally to said guides to be plate-shaped and substantially parallel and vertical, the guide element 20 comprises additional guide holes 21 sifted vertically with respect to corresponding upper and lower guide holes, where by corresponding we mean guide holes that house the same contact probe 6.

In this way, the guide element 20 of the testing head 10 according to the invention forces the positioning of the portion of probe 6B along the second direction $\beta$, forcing the contact tip 7A with the device to be tested to make a horizontal displacement, ur scrub, as desired. Moreover, advantageously according to the invention, such a scrub is determined by the guide element 20 and by its shift with respect to the lower guide 3.

In other words, the testing head 10 according to the invention essentially comprises a pair of plates 2 and 3, for supporting and guiding a plurality of contact probes 6. In particular, the first plate or upper guide 2 is equipped with a plurality of through holes or upper guide holes 4 and the second plate or lower guide 3 is equipped with a plurality of through holes or lower guide holes 5, the second plate 3 being in a position opposite and facing the first plate 2 and in a predetermined distanced relationship from it so as to define the air gap 9.

Advantageously according to the invention, the testing head 10 also comprises a third plate or guide element 20, the same as the second plate 3 or first plate 2, respectively, and positioned in the air gap 9 at such a second plate 3 or first plate 2 respectively.

In a preferred embodiment of the testing head 10 according to the invention, schematically illustrated in figure 3B, the guide element 20 has a configuration and in particular a thickness substantially corresponding to the lower guide 3. In this way, the guide element 20 is a duplicate of the lower guide 3, which can therefore be considered as consisting of two elementary guides, the same as each other, equipped with corresponding holes and suitably shifted.

It is obviously possible to deduce a configuration of the testing head 10 according to the invention in which the guide element 20 is positioned near to the upper guide 2 and the description of such a configuration shall not be repeated so as not to make the description overly weighty. In such a case, the guide element 20 of the testing head 10 according to the invention forces the positioning of a portion of probe defined by the guide element 20 and by the upper guide 2 along a predetermined direction, forcing the contact tip 7B with the space transformer to make a horizontal displacement, or scrub, as desired.

Similarly, it is possible to make a testing head 10 according to the invention comprising at least a first and a second guide element made near to the upper and lower guide 2, 3, respectively.

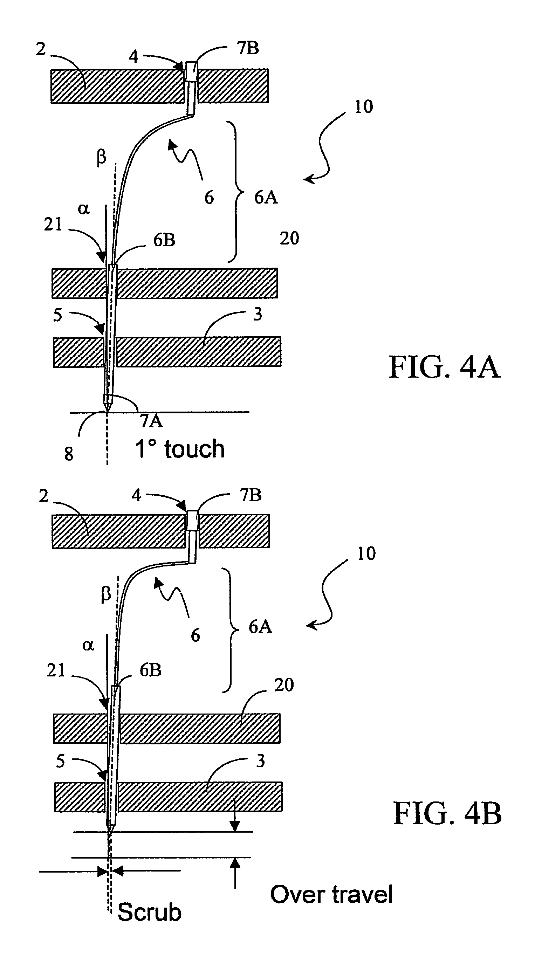

The operation of the testing head 10 according to the invention when placed in contact with a device tu be tested is schematically illustrated in figures 4A and 4B, in a first touch configuration and resting configuration pressing on such a device, respectively. In particular, figure 4B indicates the vertical displacements, in other words the overtravel, and horizontal displacements, in other words the scrub, of the contact tip 7A with the device to be tested.

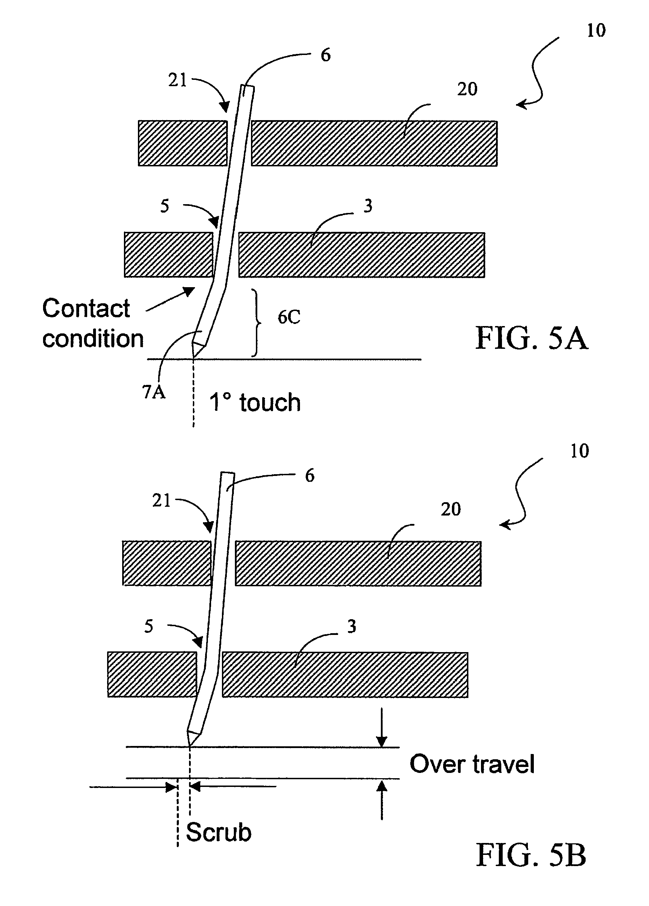

It is also possible to use the testing head 10 with non-predcformed probes, as illustrated in figures 5A and 5B, in an enlarged section at the single lower guide 3, again in a first touch configuration and resting configuration pressing on a device to be tested, respectively. In the case illustrated in such figures, the contact probe 6 comprises a section 6C inclined at the contact tip 7A.

It is obviously possible to deduce a configuration of a testing head 10 with non-predeformed probes according to the invention in which an inclined section is foreseen at the contact tip 7B with the space transformer and similarly that of a head with inclined sections foreseen at both of the contact tips 7A and 7B.

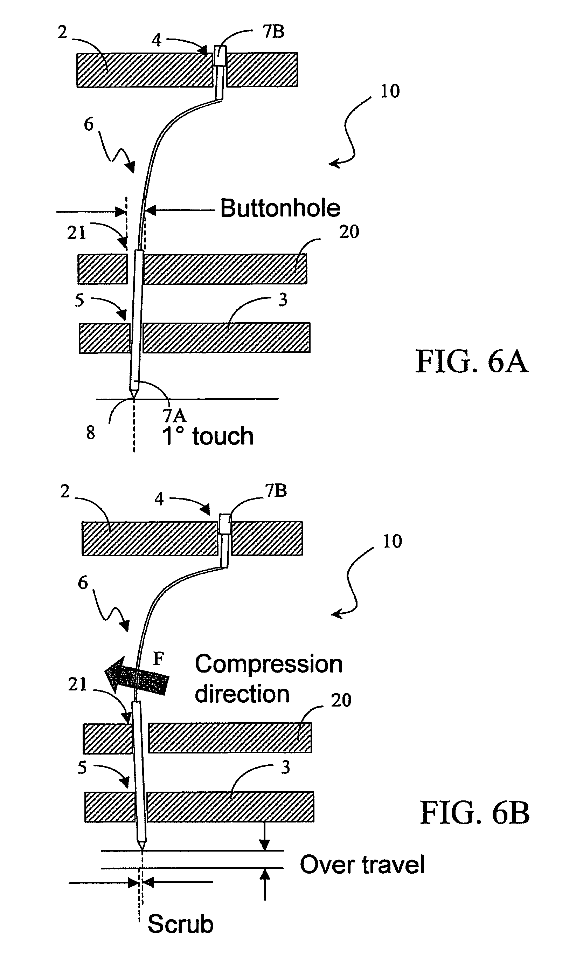

In a further variant embodiment of the testing head 10 according to the invention, the guide element 20 comprises additional guide holes 21 having a transversal size, with respect to an axis of such holes or openings, that is greater than the transversal size of the lower guide holes of the lower guide 3, as schematically illustrated in figures 6A and 6B.

In this case, in conditions resting with pressing force on a device tn be tested, the contact probe b undergoes a displacement in the direction indicated by the arrow F, such a displacement being limited by the openings of the additional guide holes 21.

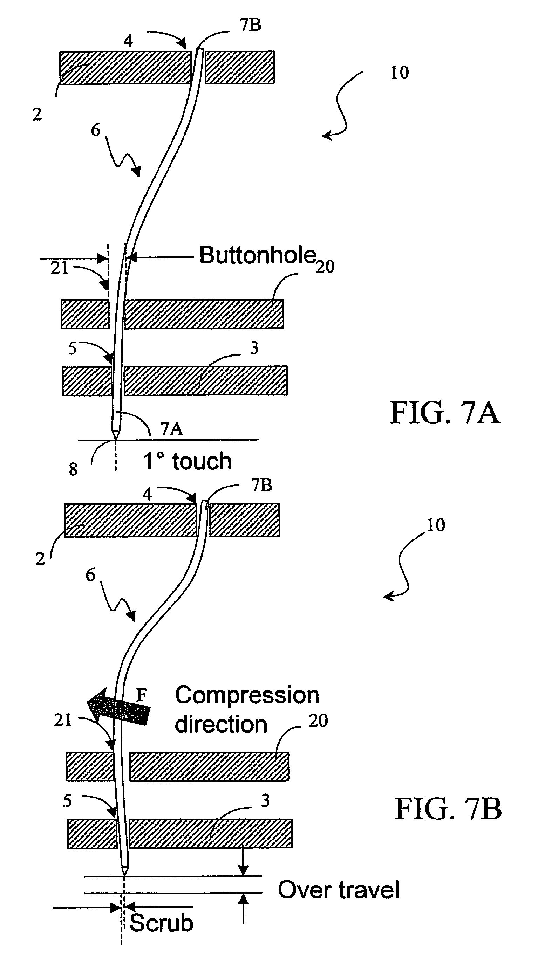

Such a variant embodiment, with non-predeformed contact probes, for example made with shifted plate technology, is schematically illustrated in figures 7A and 7B, again in a first touch configuration and resting configuration pressing on a device to be tested, respectively.

In this way, advantageously according to the invention, the testing head 10 ensures that the displacement of the contact probes 6 contained in it during their deformation when in pressing contact with the device to be tested does not exceed a predetermined value, ensuring the absence of contacts between adjacent probes.

In a preferred embodiment, the testing head 10 according to the invention comprises a plurality of contact probes with rectangular section. By using corresponding guide holes with rectangular section it is thus possible to simply and safely orientate the probes as desired.

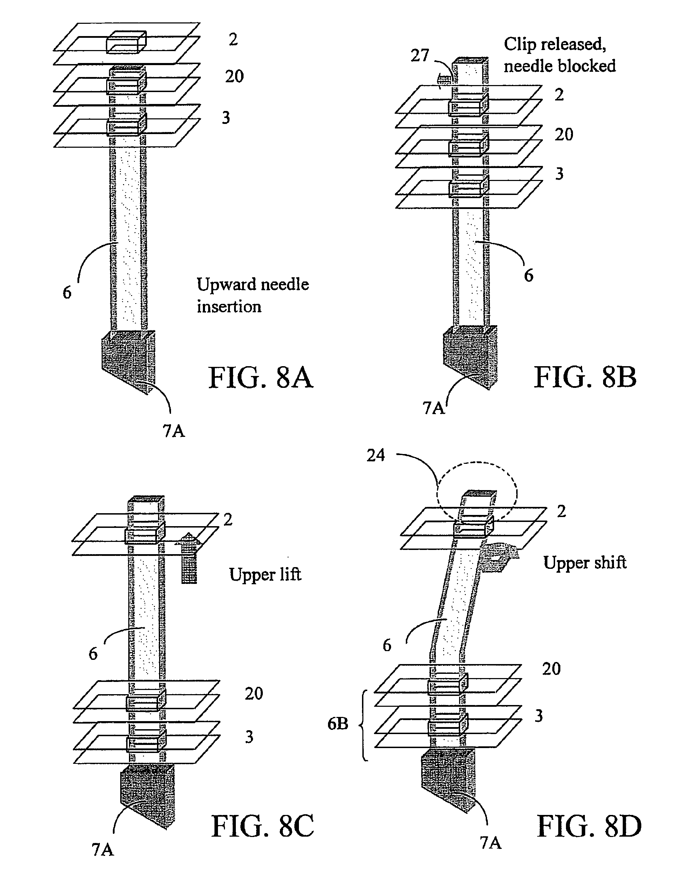

The method for assembling a testing head 10 according to the invention is extremely simple and is schematically illustrated in figures 8A-8D, in the example case of a shifted plate configuration, with guide element 20 positioned near to the lower guide 3 and with contact probes with rectangular section.

In its most general form, the assembly method according to the invention comprises the steps of:

- aligning at least a lower guide 3, a guide element 20 and an upper guide 2 in such a way that corresponding guide holes made in them arc positioned concentrically;

- slotting a plurality of contact probes 6 in such guide holes positioned concentrically;

- moving the lower guide 3 and the guide element 20 away from the upper guide 2, so as to create an air gap 9.

In particular, in the example illustrated in the figures, the assembly method comprises the following steps:

- alignment of a lower guide 3, a guides element 20 and an upper guide 2 so as to obtain corresponding guide holes positioned concentrically (figure 8A);

- slotting contact probes 6 into such guide holes positioned concentrically until the upper guide 2 has been passed by an upper portion of the probe (figure 8B);

- moving the lower guide 3 and the guide element 20 away from the upper guide 2, so as to create the air gap 9 (figure 8C); and

- shifting the upper guide 2 with respect to the lower guide 3 and the guide element 20 (figure 8D).

Furthermore, the assembly method comprises a further shift of the lower guide 3 with respect to the guide clement 20, to force the positioning of the portion of probe 6B along a predetermined direction suitable for ensuring a correct scrub of the contact tip 7A with the device to be tested.
In conclusion, the testing head according to the invention makes it possible to ensure a correct electrical contact with a device to be tested, minimising the risk of contact between adjacent probes that have undergone a deformation, thanks to their forced arrangement by the guide element.

## Claims

1. Microstructure testing head (10) of the type comprising a plurality of contact probes (6) inserted in guide holes (4, 5) made in an upper guide (2) and in a lower guide (3), separated by an air gap (9), **characterised in that** it comprises at least one guide element (20) equipped with additional guide holes (21) for the passage of said contact probes (6) and made in said air gap (9) near to at least one of said upper and lower guides (2, 3).

2. Testing head (10) according to claim 1, **characterised in that** said guide element (20) is made near to said lower guide (3).

3. Testing head (10) according to claim 1, **characterised in that** said guide element (20) is made near to said upper guide (2).

4. Testing head (10) according to claim 1, **characterised in that** it comprises said guide element (20) made near to said lower guide (3) and a further guide element made near to said upper guide (2).

5. Testing head (10) according to claim 1, **characterised in that** said guide element (20) is a plate-shaped element with a smaller thickness than a thickness of said at least one guide (2, 3), also plate-shaped.

6. Testing head (10) according to claim 1, **characterised in that** said guide element (20) is a plate-shaped element with a thickness substantially equal to a thickness of said at least one guide (2, 3), also plate-shaped.

7. Testing head (10) according to claim 1, **characterised in that** said additional guide holes (21) are made in positions corresponding to said guide holes (4, 5) of said at least one guide (2, 3).

8. Testing head (10) according to claim 1, **characterised in that** said additional guide holes (21) have a diameter substantially the same as a diameter of said guide holes (4, 5) of said at least one guide (2, 3).

9. Testing head (10) according to claim 1, **characterised in that** said additional guide holes (21) have axes substantially coinciding with axes of said guide holes (4, 5) of said at least one guide (2, 3).

10. Testing head (10) according to claim 1, **characterised in that** said additional guide holes (21) have substantially parallel axes not coinciding with axes of said guide holes (4, 5) of said at least one guide (2, 3).

11. Testing head (10) according to claim 1, **characterised in that** said additional guide holes (21) have diameters substantially the same as diameters of said guide holes (4, 5) of said at least one guide (2, 3).

12. Testing head (10) according to claim 1, **characterised in that** said additional guide holes (21) have greater diameters than said guide holes (4, 5) of said at least one guide (2, 3).

13. Testing head (10) according to any one of the previous claims, **characterised in that** said contact probes (6) have a predeformed section (6B).

14. Testing head (10) according to any one of the previous claims, **characterised in that** said contact probes (6) have an inclined section (6C) at at least one contact tip (7A).

15. Method for assembling a microstructure testing head (10) comprising the steps of:

   - aligning at least a lower guide (3), a guide element (20) and an upper guide (2) in such a way that corresponding guide holes (4, 5, 21) made in them are positioned concentrically;
   - slotting a plurality of contact probes (6) in said guide holes (4, 5, 21) positioned concentrically; and
   - moving said lower guide (3) and said guide element (30) away from said upper guide (2), so as to create an air gap (9).

**16.** Method for assembling a testing head (10) according to claim 15, wherein said moving away step is replaced by a step of moving said upper guide (2) and said guide element (20) away from said lower guide (3), so as to create an air gap (9).

**17.** Method for assembling a testing head (10) according to claim 15, further comprising a step of shifting said upper guide (2) with respect to said lower guide (3).

**18.** Method for assembling a testing head (10) according to claims 15 and 16, further comprising a step of shifting said guide element (20) with respect to at least one of said upper and lower guides (2, 3).

FIG. 1
PRIOR ART

FIG. 2
PRIOR ART

FIG. 3A

FIG. 3B

FIG. 4A

1° touch

FIG. 4B

Over travel

Scrub

FIG. 5A

FIG. 5B

FIG. 6A

FIG. 6B

FIG. 7A

Buttonhole$_{20}$

1° touch

FIG. 7B

Compression direction $_{20}$

Over travel

Scrub

2

20

3

6

Upward needle
insertion

**FIG. 8A**

7A

Clip released,
needle blocked

27

2

20

3

6

**FIG. 8B**

7A

2

Upper lift

6

20

3

**FIG. 8C**

7A

24

2

Upper shift

6

20

3

6B

**FIG. 8D**

7A

**European Patent Office**

**EUROPEAN SEARCH REPORT**

Application Number

EP 07 42 5727

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2004/005792 A1 (SABATIER ANDRE [FR] ET AL SABATIER ANDRE [FR] ET AL) 8 January 2004 (2004-01-08) * paragraph [0021] - paragraph [0038]; figure 1 * ----- | 1-12,15, 16,18 | INV. G01R1/073 |
| X | EP 1 243 931 A (TECHNOPROBE S R L [IT]) 25 September 2002 (2002-09-25) <br><br> * paragraph [0057] - paragraph [0069]; figures 6,8 * ----- | 1-4, 6-11, 13-17 | |
| X | WO 2004/036232 A (NIHON MICRONICS KK [JP]; ASO HIROYUKI [JP]; TANABE ATSUSHI [JP]; NORO) 29 April 2004 (2004-04-29) * the whole document * ----- | 1,15 | |
| X | US 4 622 514 A (LEWIS STEPHAN P [US]) 11 November 1986 (1986-11-11) * abstract; figure 4 * ----- | 1,15 | |
| X | US 6 515 496 B2 (FELICI STEFANO [IT] ET AL) 4 February 2003 (2003-02-04) * abstract; compounds 8,10 * ----- | 1 | TECHNICAL FIELDS SEARCHED (IPC) G01R |
| X | US 6 529 021 B1 (YU YUET-YING [US] ET AL) 4 March 2003 (2003-03-04) <br><br> * abstract; figures 1-3 * ----- | 1,3, 5-12,14, 15,17 | |

The present search report has been drawn up for all claims

| Place of search | Date of completion of the search | Examiner |
|---|---|---|
| Munich | 29 May 2008 | Hijazi, Ali |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
...........................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 07 42 5727

This annex lists the patent family members relating to the patent documents cited in the above-mentioned European search report.
The members are as contained in the European Patent Office EDP file on
The European Patent Office is in no way liable for these particulars which are merely given for the purpose of information.

29-05-2008

| Patent document cited in search report | | Publication date | Patent family member(s) | | Publication date |
|---|---|---|---|---|---|
| US 2004005792 | A1 | 08-01-2004 | AU<br>EP<br>FR<br>WO<br>JP | 9197701 A<br>1322966 A1<br>2815127 A1<br>0229423 A1<br>2004510986 T | 15-04-2002<br>02-07-2003<br>12-04-2002<br>11-04-2002<br>08-04-2004 |
| EP 1243931 | A | 25-09-2002 | DE<br>DE<br>IT<br>US | 60200725 D1<br>60200725 T2<br>MI20010567 A1<br>2002153910 A1 | 19-08-2004<br>04-08-2005<br>19-09-2002<br>24-10-2002 |
| WO 2004036232 | A | 29-04-2004 | AU | 2002343999 A1 | 04-05-2004 |
| US 4622514 | A | 11-11-1986 | DE<br>EP<br>JP<br>JP<br>JP | 3579502 D1<br>0164672 A2<br>1603612 C<br>2028828 B<br>61004971 A | 11-10-1990<br>18-12-1985<br>22-04-1991<br>26-06-1990<br>10-01-1986 |
| US 6515496 | B2 | 04-02-2003 | DE<br>EP<br>IT<br>US | 60110149 D1<br>1154276 A2<br>MI20001045 A1<br>2002024347 A1 | 25-05-2005<br>14-11-2001<br>12-11-2001<br>28-02-2002 |
| US 6529021 | B1 | 04-03-2003 | NONE | | |

EPO FORM P0459

For more details about this annex : see Official Journal of the European Patent Office, No. 12/82